# EUROPEAN PATENT APPLICATION

(11) **EP 0 940 817 A2**
(43) Date of publication of application: **08.09.1999**
(21) Application number: 99102135.3
(22) Date of filing: 03.02.1999
(51) Int. Cl.: G11C 8/00, G11C 7/00

(54) **Improved dynamic access memory delay circuits and methods therefor**

(30) Priority: 04.03.1998 US 34520
(71) Applicant: SIEMENS AKTIENGESELLSCHAFT, 80333 München (DE)
(72) Inventor: Hoenigschmid, Heinz, Starnberg, 82319 (DE); Haffner, Henning, Fishkill, NY 12524 (US)
(74) Representative: Patentanwälte Westphal, Mussgnug & Partner

(57) **Abstract**

A method for providing an activation signal configured to activate a sense amplifier of a memory circuit. The memory circuit has an array area for implementing memory cells is disclosed. The method includes receiving a first signal. The first signal is one of a Row Address Strobe (RAS) signal and a word line activation signal configured to activate a word line in the memory circuit. The method further includes delaying the first signal through a sample word line to create the activation signal, the sample word line being disposed in the array area of the DRAM circuit. Also, disclosed is a delay circuit for providing an activation signal configured to activate a sense amplifier of a memory circuit. The memory circuit has an array area for implementing memory cell. The delay circuit includes a sample word line having an input terminal and an output terminal. The sample word line is disposed in the array area of the circuit, and is configured to receive at the input terminal a first signal representing one of a Row Address Strobe (RAS) signal and a word line activation signal configured to activate a word line in the memory circuit. The sample word line is configured to output the activation signal at the output terminal.

## Description

### BACKGROUND OF THE INVENTION

The present invention relates to the manufacture of dynamic random access memory circuits. More particularly, the present invention relates to improved techniques for implementing a delay circuit for triggering a sense amplifier in a dynamic random access memory array.

Dynamic random access memory (DRAM) circuits are well known. In a DRAM circuit, there may be millions, even billions, of memory cells. The memory cells are typically grouped in a plurality of memory arrays, each of which contains a subset of the total number of memory cells of the DRAM circuit. By way of example, a 1-Gigabit DRAM cell may have up to 128 arrays, each of which may contain roughly 8-megabits of memory cells. The arrays may be arranged in rows and columns. For example, an 8-megabit array may be configured into 2048 rows and 4096 columns.

The rows and columns of each array are associated with a plurality of word lines and bit line pairs, respectively, and are employed to read from and/or write to each memory cell. For ease of discussion, the bit lines may be thought of as being in the vertical direction although bit lines may be either vertical or horizontal, with the word lines disposed orthogonal to the bit lines.

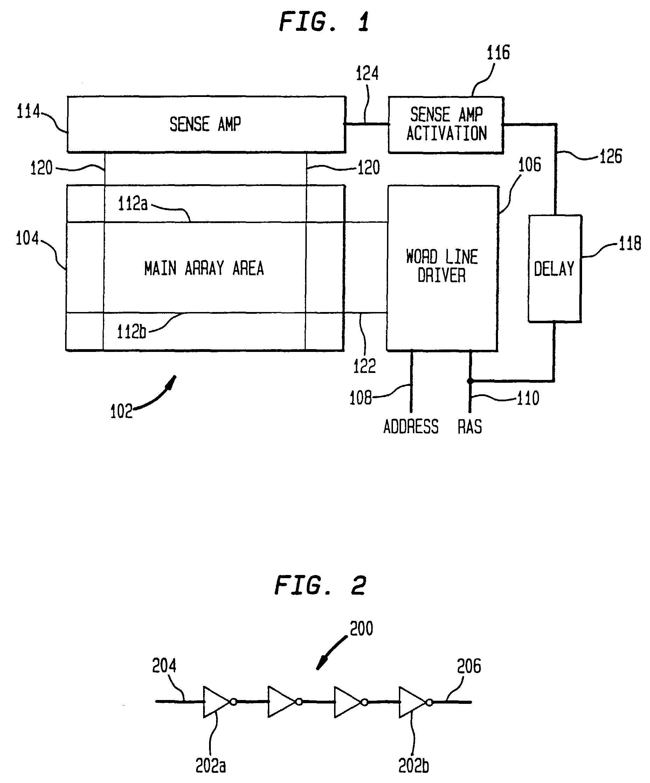

To facilitate discussion, Fig. 1 represents a conventional DRAM circuit 102. As shown, DRAM circuit 102 includes an array area 104, a sense amplifier circuit 114, a word line driver circuit 106, a sense amplifier activation circuit 116, and a delay circuit 118. Array area 104 represents the area of the DRAM circuit 102 where the memory cells are arranged in an array configuration. Array area 104 includes a plurality of word lines 112 and bit lines 120. Word line driver 106 is configured to transmit a drive signal 122 to one of the plurality of word lines in response to a user-specified address from bus 108 and a row address strobe (RAS) signal from bus 110. Each memory cell of array area 104 is configured to output a differential signal on a pair of selected bit lines 120 to be detected by sense amplifier circuit 114. For example, each memory cell includes capacitors and transistors that are used for storing and retrieving charges from the memory cell. Sense amplifier circuit 114 is configured to amplify the differential signals that are retrieved from the memory cells of array area 104.

With reference to the reading of memory cells, for example, word line driver 106 includes a row decoder (not shown), as well as a plurality of drivers. The row decoder is configured to receive the RAS signal and the user-specified address from bus 108, which specifies the DRAM memory cells in main memory array 104 which are to be read from or written to. The RAS signal received from bus 110 causes word line driver 106 to employ the address received via bus 108 to drive a particular word line (any of word line 112) to access the row of memory cells in array area 104. In response to the RAS and user-specified address, the word line driver transmits a word line activation signal 122 to activate the memory cells along one of the word lines. A corresponding column address strobe (not shown) activates the bit line in order to access particular columns in array area 104, thereby specifying the exact memory cells which the user wishes to read from or write to.

After the corresponding word line activation signal 122 is sent out on a selected one of word lines 112, there is a certain amount of delay before that signal completes its travel down selected word line 112. Because of this delay, it is important to time the activation of sense amplifier circuit 114 correctly in order to avoid activating sense amplifier circuit 114 too early (in which case the signal on the bit lines does not accurately reflect the charge of the selected capacitor) or too late (in which case the performance of DRAM circuit 102 suffers). That is, if the activation of the sense amplifier circuit is too early, the sense amplifier circuit may read erroneous data. If the activation is too late, the DRAM operates at a slower speed than is necessary and the DRAM speed is not optimized.

To activate sense amplifier circuit 114, sense amplifier activating circuit 116 receives the delayed RAS signal from delay circuit 118 and transmits a sense amplifier trigger signal 124 to sense amplifier circuit 114. The delay circuit 118 is shown disposed between bus 110 and sense amplifier activation circuit 116, and is configured to delay the activation of the sense amplifier for a sufficient amount of time to permit the word line activation signal 122 from word line driver 106 to complete its travel down the selected word line of array area 104.

There are, among many, two conventional approaches to implementing a delay circuit 118. By way of example, one conventional technique involves the implementation of delay circuit 118 by a chain of inverters. This technique is fully described in "A 14-ns 4-Mb CMOS DRAM with 300-mW Active Power." IEEE J. Solid State Circuits. vol. 27, no. 9, pp. 1222-1228, Sept. 1992 by T. Kirihata, et al, which document is herein incorporated by reference in its entirety.

Fig. 2 is an exemplary conventional delay circuit 200 that includes a chain of inverters 202, an input 204, and an output 206. As shown, the chain of inverters 202 includes an even number of inverters that are connected in series. Input 204 is configured to receive the RAS signal (e.g., bus 110 of Fig. 1). Output 206 is configured to transmit a sense amplifier activation signal (e.g., 126) to a sense amplifier activation circuit (e.g., 116). It should be well understood to those skilled in the art that the chain of inverters may take various forms that are suitable for delaying the RAS signal for a sufficient amount of time to allow the word line activation signal (e.g., 122) to activate the entire word line (e.g., 112a).

Another conventional approach for implementing a delay circuit is to use sample word lines in a sample array that are positioned outside array area (e.g., 104). An example of a sample array is described in detail in "A 22-ns 1-Mbit CMOS high-speed DRAM with address multiplexing," IEEE J. Solid State Circuits, vol 24, pp. 1198-1205, Oct. 1989 by N.C.C. Lu et al., which document is herein incorporated by reference in its entirety. The sample array typically includes the same structures that are found in array area. In other words, the sample array is configured, by itself, to have the same delay as one of the word lines in array area (e.g., 112a). However, since the sample array is positioned outside of array area, the RAS signal, (e.g., bus 110) must be routed to the sample array which may be a substantial distance away from the word line circuit to be activated. After being delayed through the sample word line, the delayed RAS signal is routed back to sense amplifier activation circuit (e.g., 116). Thus, the routing substantially increases the delay associated with the implementation of the sample array.

Convention delay circuits for DRAM circuits have many disadvantages. For example, the implementation of an inverter chain (e.g., 200 of Fig. 2) delay circuit requires the performance of two simulations to determine the correct inverter chain configuration. A first simulation must be performed to determine the maximum activation delay within the active word line, and a second simulation must be performed to ascertain whether a particular delay chain design can properly delay the RAS signal for the determined maximum delay time. The results of these two simulations are then compared and the delay circuit is adjusted accordingly. Unfortunately, each simulation introduces a margin of error into the results of the simulation. Thus, by performing two simulations, the simulation errors are compounded.

Further, since the delay implemented by the inverter chain is dependent on device characteristics whereas the actual delay experienced by the word line signal is dependent on the dimensional characteristics of the word line, variations introduced by manufacturing tolerance, temperature, and the like, tend to affect the inverter chain delay and the actual word line delay differently. As such, it is not uncommon to find a significant error in the inverter chain delay.

Likewise, the implementation of a sample array requires two simulations. That is, since the routing between the sample array and sense amplifier activation circuit also introduces a substantial amount of additional delay, the sample array must be sized such that the total delay through the routing and sample array is substantially equal to the activation delay of a word line. Thus, the activation delay for the word line must be determined by a simulation, and the sample array and routing delay must be determined by a separate simulation and compared with the activation delay. As discussed earlier, compounded simulation errors may be experienced under such an approach. Also, the routing itself introduces additional structures (e.g., additional conductors) in the DRAM circuit, which disadvantageously increases power consumption and circuit size.

In view of the foregoing, there is a need for an improved DRAM circuit design, and more specifically, an improved delay circuit for the DRAM circuit.

### SUMMARY OF THE INVENTION

A method for providing an activation signal configured to activate a sense amplifier of a dynamic random access memory (DRAM) circuit is disclosed. The DRAM circuit has an array area for implementing memory cells. The method includes receiving a first signal. The first signal is one of a Row Address Strobe (RAS) signal and a word line activation signal configured to activate a word line in the DRAM circuit. The method further includes delaying the first signal through a sample word line to create the activation signal, the sample word line being disposed in the array area of the DRAM circuit.

In another embodiment, a delay circuit for providing an activation signal configured to activate a sense amplifier of a dynamic random access memory (DRAM) circuit is disclosed. The DRAM circuit has an array area for implementing memory cell. The delay circuit includes a sample word line having an input terminal and an output terminal. The sample word line is disposed in the array area of the DRAM circuit, and is configured to receive at the input terminal a first signal representing one of a Row Address Strobe (RAS) signal and a word line activation signal configured to activate a word line in the DRAM circuit. The sample word line is configured to output the activation signal at the output terminal.

In another embodiment, a method for forming a delay circuit in a dynamic random access memory (DRAM) circuit is disclosed. The delay circuit is configured to activate a sense amplifier of the dynamic random access memory (DRAM) circuit. The DRAM circuit has an array area for implementing memory cells. The method includes providing a sample word line in the array area. The sample word line has an input terminal and an output terminal. The method further includes coupling the input terminal to receive a first signal. The first signal is one of a Row Address Strobe (RAS) signal and a word line activation signal configured to activate a word line in the DRAM circuit.

### BRIEF DESCRIPTION OF THE DRAWINGS

The present invention is illustrated by way of example, and not by way of limitation, in the figures of the accompanying drawings and in which like reference numerals refer to similar elements and in which:
Fig. 1 represents a conventional DRAM circuit.
Fig. 2 is a conventional delay circuit that includes a chain of inverters.
Fig. 3 is a diagrammatic representation of an array area in accordance with one embodiment of the present invention.
Fig. 4 is a diagrammatic representation of a sample word line in accordance with one embodiment of the current invention.
Fig. 5 is a diagrammatic representation of a sample word line in accordance with an alternative embodiment of the current invention.
Fig. 6 is a top view of the connection between two halves of the sample word line of Fig. 6.
Fig. 7 is a diagrammatic representation of a memory bank in accordance with one embodiment of the present invention.

### DETAILED DESCRIPTION OF THE INVENTION

The present invention will now be described in detail with reference to a few illustrative embodiments as shown in the accompanying drawings. In the following description, numerous specific details are set forth in order to provide a thorough understanding of the present invention. It will be apparent, however, to one skilled in the art, that the present invention may be practiced without some or all of these specific details. In other instances, well known process steps and/or structures have not been described in detail in order to not unnecessarily obscure the present invention.

In accordance with one aspect of the present invention, the delay circuit, or delay monitoring circuit, is incorporated within array a memory integrated circuit. The memory integrated circuit includes, for example, a dynamic random access memory (DRAM), a synchronous DRAM (SDRAM), a merged DRAM-logic circuit (embedded DRAM), or other circuit. The memory integrated circuit is used in, for example, consumer products such as computer systems, cellular phones, personal digital assistants (PDAs), and other electronic products. The delay circuit, in one embodiment, is incorporated within the array area of the memory integrated circuit..

In other words, a portion of array area contains the delay circuit. In general terms, the present invention takes advantage of existing dummy word lines within array area. Dummy word lines are typically deposited at the edge of array area for photolithography purposes. Instead of using these dummy word lines merely for photolithography purposes, some or all of the dummy word lines are also utilized as a delay circuit.

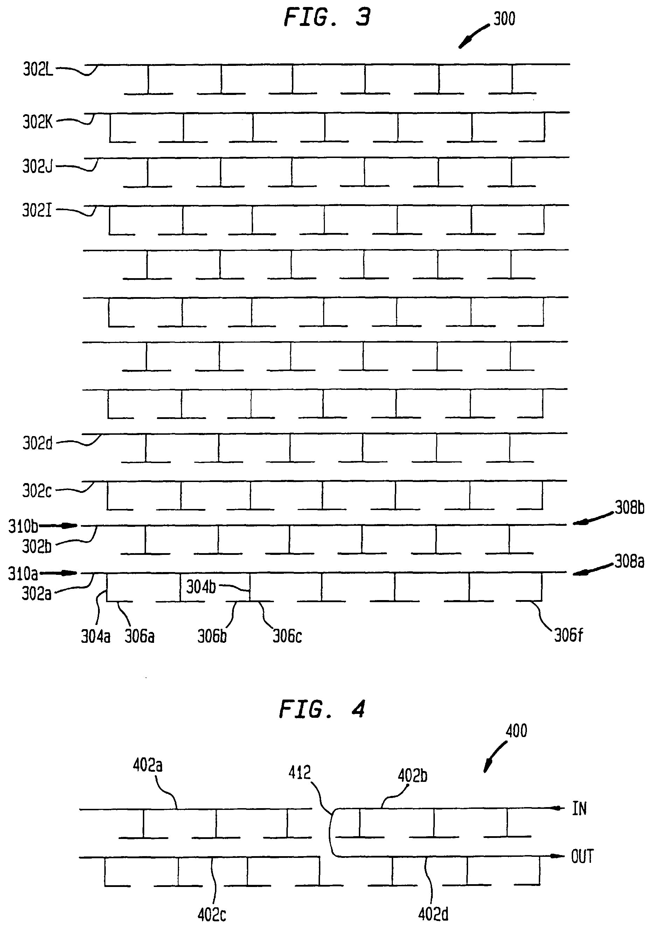

Fig. 3 is a diagrammatic representation of an array area 300 in accordance with one embodiment of the present invention. Array area 300 includes a plurality of word lines 302. These word lines 302 are typically formed from a conductive material, such as metal. The main array portion 300 includes bit lines (not shown) that are preferably positioned below the word lines 302. Typically, a pair of bit lines connect to an associated memory cell -- one bit line for the value of the associated memory cell and another bit line for the inverse of the value of the associated memory cell. Such a configuration is known as a folded bit line architecture. Other type of bit line architectures such as open or open-folded are also useful. The bit lines are typically formed from a conductive metal, although the bit lines may be formed from any suitable conductive material.

Array area may be implemented in the form of any suitable type of architecture. In this embodiment, a "stitched word line architecture" will be described. Of course, other architectures may be utilized in the current invention. In a stitch architecture, each word line 302 is coupled with a plurality of gate conductor (GC) pieces 306 through a plurality of conductive vias 304, where each GC piece represents the gates of the transistor that controls the memory cell. Since the GC piece typically has a higher resistivity than word line 302, which is typically formed from a conductive material, the word line is used to "stitch" the word line activation signal down to the GC pieces. For example, a word line may have a resistivity of about 0.2 ohms per square, while a GC piece may have a resistivity of about 15 ohms per square. As shown, the conductive vias 304 couple the word line to either a pair of GC pieces or a single GC piece. For example, via 304a couples word line 302a with GC piece 306a. In contrast, conductive via 304b couples word line 302a with GC pieces 306b and 306c.

Additionally, each GC piece is also coupled with a bit line (not shown). Some conductive vias (e.g., 304a) are connected to a GC piece, which piece is coupled with 256 bit line pairs, while other conductive vias (e.g., 304b) are connected to a GC piece, which piece is coupled with 512 (2 times 256) bit line pairs. Thus, each word line 302 is coupled with a plurality of bit line pairs. By way of example, in a 8-megabit memory cell, one word line may be coupled with 4096 bit line pairs.

In reference to the reading of memory cells, a driver end 308 of each word line 302 is coupled with word line driver. (The driver end of each word line is opposite a nondriver end 310). The word line driver transmits a word line activation signal to the driver end of a selected one of the word lines (e.g., 302a) to activate the memory cells along the selected word line. The word line activation signal travels from the driver end (e.g., 308a) to the nondriver end (e.g., 310a) of the selected word line. As the word line activation signal travels down the length of the word line, each GC piece is activated. However, there is a certain amount of delay before the word line activation signal completes its travel down the selected word line (e.g., 302a) and activates all of the memory cells within the selected word line. By way of example, the word line may have a length of about 2.8 mm, and as a result of the resistivity of the word line, there is a delay of about 8 ns between the activation of the first GC piece (e.g., 306f) and the activation of the last GC piece (e.g., 306a). As each GC piece is activated, a differential signal (or pair of bit line signals) is output on the bit line pairs. These differential signals are then amplified by a sense amplifier circuit.

As previously discussed, it is important to time the activation of the sense amplifier circuit correctly in order to avoid activating sense amplifier circuit too early (in which case the signal on the bit line does not accurately reflect the charge of the selected capacitor) or too late (in which case the performance of DRAM circuit suffers). Thus, a delay circuit is required for triggering the sense amplifier at a delayed time. For example, if the maximum difference in GC piece activation time is 8 ns, the delay circuit needs to delay triggering the sense amplifier circuit for a time that is at least greater than about 8 ns, and preferably not much longer than about 8 ns.

At the edge of the array, two to four dummy word lines are typically located in parallel to the active word lines. For example, word lines 302I through 302L may be in the form of dummy word lines. The dummy word lines are typically used for photolithography purposes. In accordance with one aspect of the present invention, some of these dummy word lines are implemented in the current invention as a delay circuit, or a sample word line.

Fig. 4 is a diagrammatic representation of a sample word line 400 in accordance with one embodiment of the current invention. The sample word line 400 includes a pair of dummy word lines 402 that are split into two portions. As shown, a first dummy word line is split into a drive portion 402b and a non-drive portion 402a, and a second dummy word line is split into an output portion 402d and a non-output portion 402c. The drive portion 402b of the first dummy word line is coupled with the output portion 402d of the second dummy word line. In this embodiment, a connector 412 couples the two dummy word lines together by directly attaching to two dummy word lines. Although the connector 412 is described as being formed from the metal layer that includes the word line, the connector 412 may be formed from any suitable conductive material.

The drive portion 402b of the first dummy word line is configured to receive a word line activation signal (e.g., 122 of Fig. 1) from the word line driver (e.g., 106). Word line activation is preferable since it may take up to 0.5 ns for a decoder to calculate the correct wordline from a RAS and address. Alternatively, the drive portion may be configured to receive the RAS signal. As previously discussed above, the word line activation signal also activates the memories cells within a selected word line. The word line activation signal travels down the length of the drive portion 402b of the first dummy word line, travels up the output portion 402d of the second dummy word line, and is output as a sense amplifier activation signal (e.g., 126). The sense activation signal is received by a sense amplifier activation circuit (e.g., 116) to permit the sense amplifier to sense the charge of the selected memory cell..

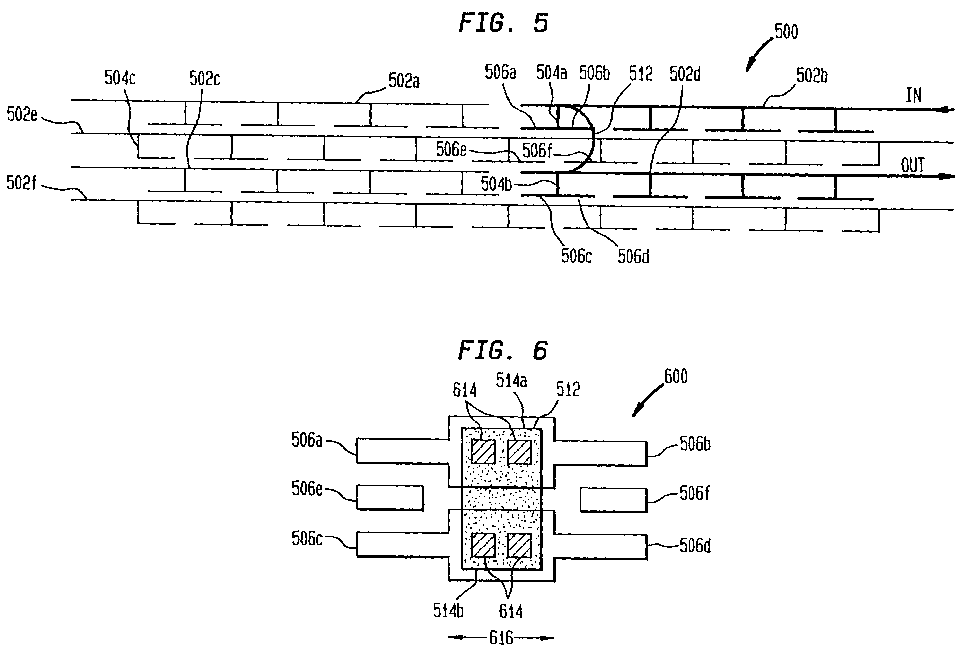

An alternative embodiment of a sample word line will now be described with reference to Figs. 5 and 6. Fig. 5 is a diagrammatic representation of a sample word line 500 in accordance with an alternative embodiment of the current invention. Fig. 6 is a top view of the connection between two halves of the sample word line of Fig. 5. In this alternative embodiment, the connection between the two halves of the sample word line may be formed on a conductive layer that includes either bit lines or word lines of the DRAM circuit.

Like the sample word line 400 in Fig. 4, the sample word line 500 includes a pair of dummy word lines, wherein each of the pair of word lines is split into two portions. As shown, a first dummy word line is split into a drive portion 502b and a non-drive portion 502a, and a second dummy word line is split into an output portion 502d and a non-output portion 502c. In contrast to the split dummy word lines of Fig. 4, the split dummy word lines of the sample word line 500 are interleaved between nonsplit dummy word lines 502e and 502f. Alternatively, the split dummy word lines of the sample word line 500 are interleaved between actual word lines.

Like the actual word lines, the dummy word lines are connected to a plurality of GC pieces through a plurality of conductive vias. As shown, conductive via 504a of the drive portion 502b is coupled with GC pieces 506a and 506b. Likewise, conductive via 504b of the output portion is coupled with GC pieces 506c and 506d.

As shown in Fig. 5, a connector 512 couples the drive portion 502b of the first dummy word line with the output portion 502d of the second dummy word line. A top view of the connection 512 without the word lines is illustrated in Fig. 6. A first end 514a of the connector 512 is positioned over a first stitch region of the drive portion 502b of the first dummy word line (see Fig. 5). The first stitch region includes, for example, the conductive via 504a and GC pieces 506a and 506b. A second end 514b of the connector 512 is positioned over a second stitch region of the output portion 502d of the second dummy word line (e.g., conductive via 504b and GC pieces 506c and 506d). In this embodiment, the connector 512 is also positioned between the GC pieces 506e and 506f of adjacent dummy word line 502e.

Preferably, the connection 512 is formed from the conductive layer that includes the bit line pairs and is positioned within the stitch region(e.g., 504a and 504b). By way of example, the connection 512 may be formed from metal 0 layer, which is disposed above the GC layer, but below the layer implementing drive portion 502b and output portion 502d. Alternatively, the connection 512 is formed from the conductive layer that includes the word line, which is above the bit line pairs and GC pieces. By way of example, the connection 512 may be formed from a metal 1 layer , which layer is disposed above the GC layer and a metal 0 layer. As shown in Fig. 6, each stitch region requires extra space 616 for the formation of the conductive vias. Thus, the connection 512 is preferably made between the stitch regions and associated extra space of the adjacent dummy word line (e.g., 502e). In other words, since the stitch regions of the adjacent dummy word line 502e are offset from the stitch regions of the drive portion 502b and output portion 502d, the connection 512 is preferably formed between stitch regions of the adjacent dummy word line 502e.

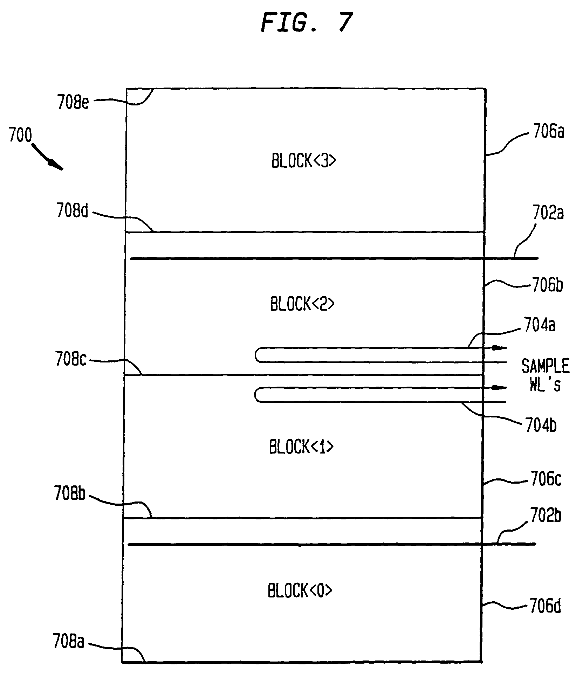

Fig. 7 is a diagrammatic representation of a memory bank 700 in accordance with one embodiment of the present invention. As shown, the memory bank includes a plurality of memory blocks 706 that are arranged contiguously. The memory bank 700 also includes a plurality of sense amplifier circuits 708 that are interleaved between each memory block. For example, sense amplifier circuit 708b is between memory blocks 706d and 706c. Each memory block includes a plurality of word lines 702, bit line pairs (not shown to simplify the illustration), and a sample word line 704 that is formed from a pair of dummy word lines. For example, each block represents an 8-megabit array having 4096 bit line pairs and 2048 word lines. Each sense amplifier circuit is configured to receive 2048 bit line pairs. For example, sense amplifier circuit 708a receives the even 2048 bit line pairs from block 706d, and the sense amplifier circuit 708b receives the odd 2048 bit line pairs from block 706d. Also, each sense amplifier is configured to receive bit lines from both adjacent memory block. For example, sense amplifier circuit 708b receives bit lines from both memory blocks 706c and 706d. However, only one word line from one memory block is active at one time.

As discussed above, each word line is activated by a word line activation signal from word line driver (not shown), and each sample word line receives the word line activation signal (or RAS signal) and outputs a sense amplifier activation signal. In this embodiment, more than one word line may be activated at a time in order to retrieve more bits from the memory bank 700. As shown, word line 702a of block 706b and word line 702b of block 706d are active. Preferably, however, sample word lines of adjacent nonactivated blocks (e.g., 706a and 706c) are utilized to prevent the sample word lines from causing an erroneous activation of bits within the active blocks. For example, when word lines 702b and 702a of blocks 706d and 706b are active, sample word line 704b is preferably utilized. By way of another example, when word lines are activated within blocks 706a and 706c, the sample word line 704a is preferably utilized.

The current invention has many advantages. For example, since the delay circuit, or sample word line, is incorporated directly into the array area by utilizing existing dummy word lines to form the delay circuit, extra space is not required for the implementation of the delay circuit. Additionally, since the delay circuit is incorporated within the array area and the routing to and from the delay circuit is minimal, the delay time for the word line activation signal to travel through the delay circuit and back out to the sense amplifier activation circuit is substantially reduced as compared with conventional delay circuits, where the delay circuit sample array is positioned at a substantial distance from the sense amplifier activation circuit. Additionally, since the delay circuit is formed in substantially the same manner as an actual word line and has the same delay characteristics as an actual word line, simulation of the delay circuit or actual word line is not required to match the delays of the delay circuit and the actual word line.

While this invention has been described in terms of several illustrative embodiments, there are alterations, permutations, and equivalents which fall within the scope of this invention. It is therefore intended that the following appended claims be interpreted as including all such alterations, permutations, and equivalents as fall within the true spirit and scope of the present invention.

## Claims

1. A method for providing an activation signal configured to activate a sense amplifier of a memory circuit, the memory circuit having an array area for implementing memory cells, comprising:
receiving a first signal, the first signal being one of a Row Address Strobe (RAS) signal and a word line activation signal configured to activate a word line in the memory circuit;
delaying the first signal through a sample word line to create the activation signal, the sample word line being disposed in the array area of the memory circuit.

2. The method of claim 1 further comprising providing the activation to an input terminal of the sense amplifier.

3. The method of claim 1 wherein the first signal is the RAS signal.

4. The method of claim 1 wherein the first signal is the word line activation signal, the word line activation signal being generated by a word line driver circuit of the DRAM circuit responsive to a received address and the RAS signal.

5. The method of claim 1 wherein the sample word line comprises two parallel word line portions in the array area, a total delay through the two parallel word lines portions substantially equals a maximum delay through the word line.

6. The method of claim 5 wherein a first one of the two parallel word line portions is a part of a first split dummy word line in the array area that is proximal to the word line driver circuit, a second one of the two parallel word line portions is a part of a second split dummy word line in the array area that is proximal to the word line driver circuit, the sample word line including a connector coupling the first one and the second one of the two parallel word lines.

7. The method of claim 6 wherein the first split dummy word line and the second split dummy word line are separated by at least one interleaved word line, the interleaved word line being one of an active word line and a dummy word line.

8. The method of claim 6 wherein the connector is formed out of a first conductive layer, the first conductive layer including the sample word line.

9. The method of claim 6 wherein the connector is formed out of a first conductive layer, the first conductive layer including bit lines of the memory circuit.

10. The method of claim 9 wherein the first conductive layer is disposed between an overlying conductive layer and a gate conductor layer, the overlying conductive layer representing a layer for forming the sample word line, the gate conductor layer representing a layer for forming gates of transistors associated with the memory cells.

11. A delay circuit for providing an activation signal configured to activate a sense amplifier of a memory circuit, the memory circuit having an array area for implementing memory cells, comprising:
a sample word line having an input terminal and an output terminal, the sample word line being disposed in the array area of the memory circuit, the sample word line being configured to receive at the input terminal a first signal representing one of a Row Address Strobe (RAS) signal and a word line activation signal configured to activate a word line in the memory circuit, the sample word line being configured to output the activation signal at the output terminal.

12. The delay circuit of claim 11 wherein the output terminal is coupled to an input terminal of the sense amplifier.

13. The delay circuit of claim 11 wherein the first signal is the RAS signal.

14. The delay circuit of claim 11 wherein the first signal is the word line activation signal, the word line activation signal being generated by a word line driver circuit of the memory circuit responsive to a received address and the RAS signal.

15. The delay circuit of claim 11 wherein the sample word line comprises two parallel word line portions in the array area, a total delay through the two parallel word lines portions substantially equals a maximum delay through the word line.

16. The delay circuit of claim 15 wherein a first one of the two parallel word line portions is a part of a first split dummy word line in the array area that is proximal to the word line driver circuit, a second one of the two parallel word line portions is a part of a second split dummy word line in the array area that is proximal to the word line driver circuit, the sample word line including a connector coupling the first one and the second one of the two parallel word lines.

17. The delay circuit of claim 16 wherein the first split dummy word line and the second split dummy word line are separated by at least at least one interleaved word line, the interleaved word line being one of an active word line and a dummy word line.

18. The delay circuit of claim 16 wherein the connector is formed out of a first conductive layer, the first conductive layer including the sample word line.

19. The delay circuit of claim 16 wherein the connector is formed out of a first conductive layer, the first conductive layer including bit lines of the memory circuit.

20. The delay circuit of claim 19 wherein the first conductive layer is disposed between an overlying conductive layer and a gate conductor layer, the overlying conductive layer representing a layer for forming the sample word line, the gate conductor layer representing a layer for forming gates of transistors associated with the memory cells.

21. A method for forming a delay circuit in a dynamic random access memory (DRAM) circuit, the delay circuit being configured to activate a sense amplifier of the dynamic random access memory (DRAM) circuit, the DRAM circuit having an array area for implementing memory cells, comprising:
providing a sample word line in the array area, the sample word line having an input terminal and an output terminal; and
coupling the input terminal to receive a first signal, the first signal being one of a Row Address Strobe (RAS) signal and a word line activation signal configured to activate a word line in the DRAM circuit.

22. The method of claim 21 wherein the sample word line comprises two parallel word line portions in the array area, a total delay through the two parallel word lines portions substantially equals a maximum delay through the word line.

23. The method of claim 22 wherein a first one of the two parallel word line portions is a part of a first split dummy word line in the array area that is proximal to the word line driver circuit, a second one of the two parallel word line portions is a part of a second split dummy word line in the array area that is proximal to the word line driver circuit, the sample word line including a connector coupling the first one and the second one of the two parallel word lines.

24. The method of claim 23 wherein the first split dummy word line and the second split dummy word line are separated by at least one interleaved word line, the interleaved word line being one of an active word line and a dummy word line.

25. The method of claim 23 wherein the connector is formed out of a first conductive layer, the first conductive layer including the sample word line.

26. The method of claim 23 wherein the connector is formed out of a first conductive layer, the first conductive layer including bit lines of the DRAM circuit.

27. The method of claim 24 wherein the first conductive layer is disposed between an overlying conductive layer and a gate conductor layer, the overlying conductive layer representing a layer for forming the sample word line, the gate conductor layer representing a layer for forming gates of transistors associated with the memory cells.
